# EUROPÄISCHE PATENTSCHRIFT

(11) **EP 1 992 000 B1**
(45) Veröffentlichungstag und Bekanntmachung des Hinweises auf die Patenterteilung: **30.10.2013**
(21) Anmeldenummer: 06706013.7
(22) Anmeldetag: 23.02.2006
(51) Int. Cl.: H01H 39/00, H01H 79/00, H02H 3/02, H01L 23/62

(54) **EINRICHTUNG ZUM KURZSCHLIESSEN VON LEISTUNGSHALBLEITERMODULEN**
DEVICE FOR SHORT-CIRCUITING POWER SEMICONDUCTOR MODULES
DISPOSITIF DE MISE EN COURT-CIRCUIT DE MODULES DE PUISSANCE SEMI-CONDUCTEURS

(43) Veröffentlichungstag der Anmeldung: 19.11.2008
(73) Patentinhaber: Siemens Aktiengesellschaft, 80333 München (DE)
(72) Erfinder: DOMMASCHK, Mike, 01945 Guteborn (DE); DORN, Jörg, 96155 Buttenheim (DE); HOLWEG, Johann, 90513 Zirndorf (DE); LANG, Jörg, 95346 Stadtsteinach (DE); PREIDEL, Axel, 91054 Buckenhof (DE); WÜRFLINGER, Klaus, 90419 Nürnberg (DE)
(86) Internationale Anmeldenummer: PCT/DE2006/000344
(87) Internationale Veröffentlichungsnummer: WO 2007/095873

(56) Entgegenhaltungen:
- EP-A- 1 282 145
- WO-A-97/41582
- GB-A- 1 321 381
- GB-A- 2 153 609

## Beschreibung

Die Erfindung betrifft eine Vorrichtung mit Leistungshalbleitermodulen, die über Verbindungsmittel unter Ausbildung einer Reihenschaltung miteinander verbunden sind, wobei jedem Leistungshalbleitermodul eine Kurzschlusseinrichtung zum Kurzschließen des jeweiligen Leistungshalbleitermoduls zugeordnet ist.

Eine solche Vorrichtung ist aus der DE 103 23 220 A1 bereits bekannt. Dort ist ein Umrichter beschrieben, der eine Brückenschaltung mit Brückenzweigen umfasst. Dabei weist jeder Brückenzweig eine Reihenschaltung aus Leistungshalbleitermodulen auf, die über Verbindungsmittel miteinander verbunden sind. Die zweipoligen Leistungshalbleitermodule weisen bei verschiedenen steuerbaren Schaltzuständen eine unterschiedliche Klemmspannung auf. Jedes Leistungshalbleitermodul umfasst ferner einen internen Spannungszwischenkreis mit einem Energiespeicher. Die Leistungshalbleitermodule sind nicht über Druckkontakt der jeweiligen Leistungshalbleiter miteinander verbunden. Ein Kurzschluss innerhalb des Leistungshalbleitermoduls kann daher zum Auftreten von Lichtbögen führen, mit Explosionsgasen oder dergleichen im Gefolge. Um dem Lichtbogen die treibende Spannung zu entziehen, wird das fehlerhafte Leistungshalbleitermodul kurzgeschlossen und auf diese Weise in der Reihenschaltung überbrückt. Zum Kurzschließen ist dem Leistungshalbleitermodul eine Kurzschlusseinrichtung parallel geschaltet, die ein Opferbauelement aus Halbleitern umfasst. Das Opferbauelement legiert beim Kurzschließen im Fehlerfall durch, wobei es zerstört wird. Die vorbekannte Kurzschlussvorrichtung weist jedoch einen komplizierten Aufbau auf und ist kostenintensiv.

Aus der DE 199 55 682 A2 ist eine strombegrenzende Einrichtung für die Hochspannung bekannt, die über eine Sprengladung zum Öffnen eines Hauptstromzweiges verfügt. Nach dem Öffnen des Hauptstromzweiges kommutiert der Strom auf einen einen Kondenstor aufweisenden Nebenzweig. In Abhängigkeit der Impedanz des Kondensators kommt es zu einer Begrenzung des über die Einrichtung fließenden Stromes.

Die DE 102 54 497 B3 offenbart einen Kurzschließer mit einem Lichtempfänger, dessen optisches Ausgangssignal zur Aktivierung einer photochemischen Reaktion eines Reaktionsgemisches eingesetzt wird. Dazu wird das Licht eines entstandenen Störlichtbogens über Lichtwellenleiter in eine Reaktionskammer geführt, die mit dem Reaktionsgemisch befüllt ist. Durch die photochemische Zündung des Reaktionsgemisches kommt es zur explosionsartiger Druckerhöhung in der Kammer, wodurch wiederum ein Kurzschließer mechanisch betätigt wird.

Aus der DE 225 540 A1 ist ferner ein Antrieb für elektrische Schalter mit Explosivzündung bekannt.

Aus der EP 1 282 145 A1 ist eine Kurzschlusseinrichtung beschrieben, die von einem Lichtbogen gezündet wird. Die Kurzschlussvorrichtung weist hierzu einen ersten Anschluss sowie einen zweiten Anschluss auf, an denen bei Normalbetrieb eine Betriebsspannung abfällt. Der erste Anschluss ist leitend mit einem becher- oder hutförmigen Kontaktierungsmittel verbunden, in dem Standardpyrotechnika angeordnet sind. Das Kontaktierungsmittel ist dem zweiten Anschluss zugewandt. Übersteigt die zwischen dem Kontaktierungsmittel und dem diesen zugewandten Anschluss abfallende Spannung einen zuvor festgelegten Schwellenwert, kommt zur Ausbildung eines Lichtbogens, der das Standardpyrotechnika im Inneren des Kontaktierungsmittels zündet. Es kommt zu einer Verschiebung des Kontaktierungsmittels unter Ausbildung eines leitenden Kontaktes zwischen den besagten Anschlüssen über das Kontaktierungsmittel. Die auf diese Weise selbstzündende Kurzschlusseinrichtung ist in einem Anwendungsbeispiel parallel zu ansteuerbaren Leistungshalbleitern geschaltet, die sich ebenfalls zwischen den Anschlüssen erstrecken. Die Kurzschlusseinrichtung sowie die parallel geschalteten Leistungshalbleiter sind in einem gemeinsamen Gehäuse angeordnet.

Aufgabe der Erfindung ist es, eine Vorrichtung der eingangs genannten Art bereitzustellen, die eine zuverlässige und gleichzeitig kostengünstige Kurzschlusseinrichtung aufweist.

Die Erfindung löst diese Aufgabe dadurch, dass die Kurschlusseinrichtung ein pyrotechnisch-mechanisches Element ist, das einen Sprengsatz und ein durch den Sprengsatz verschiebbares Auslösemittel aufweist, wobei das pyrotechnisch-mechanische Element aus einem elektrisch leitfähigen Material besteht und in einer Auslösestellung die Reihenschaltung mit einem Umgehungszweig verbindet, so dass das dem pyrotechnisch-mechanische Element zugeordnete Leistungshalbleitermodul kurzgeschlossen ist, und wobei das pyrotechnisch-mechanische Element elektrisch zündbar ist und ein Gehäuse aufweist, in dem der Sprengsatz angeordnet ist.

Im Rahmen der Erfindung wird ein kostengünstiges pyrotechnisch-mechanisches Element zum Überbrücken eines Leistungshalbleitermoduls verwendet. Solche pyrotechnisch-mechanischen Elemente sind beispielsweise als Gurtstraffer oder zum Öffnen von gepanzerten Fahrzeugen bekannt geworden. Sie weisen neben einer schnellen Reaktionszeit eine extrem hohe Zuverlässigkeit auf. Ferner wird nur eine begrenzte Energie zum Auslösen des Sprengsatzes benötigt, wobei jedoch über die entstehende Druckwelle hohe Kräfte in das beweglich in den restlichen Bauteilen des pyrotechnisch-mechanischen Elements gelagerte Auslösemittel eingeleitet werden. Zweckmäßigerweise ist das Auslösemittel im Auslösefall nur über eine vorbestimmte Wegstrecke hinweg beweglich gelagert. Auf diese Weise kann die Beschädigung empfindlicher Bauteile der erfindungsgemäßen Vorrichtung noch weiter vermieden werden. Erfindungsgemäß ist auch bei langen Lebensdauern ein zuverlässiges Schalten ermöglicht. Der Einsatz des pyrotechnisch-mechanischen Elements ermöglicht daher die Konstruktion von erfindungsgemäßen Vorrichtungen, wie beispielsweise Stromrichtern, die modulartig aufgebaut sind, wobei die einzelnen Module über Verbindungsmittel verbunden sind. Eine aufwändige Druckkontaktierung der einzelnen Leistungshalbleiter ist daher überflüssig geworden. Die Stromrichter sind somit kostengünstig herstellbar. Bei einem Kurzschluss kann das fehlerhafte Leistungshalbleitermodul mittels des pyrotechnisch-mechanischen Elementes sicher kurzgeschlossen werden, so dass Beschädigungen der restlichen Bauteile des Stromrichters oder von Personen in der Nähe des Stromrichters erfindungsgemäß zuverlässig vermieden sind. Zwar sind pyrotechnische Auslösungen im Bereich der Energieverteilung bereits bekannt geworden. Erfindungsgemäß wurde jedoch erkannt, dass Sprengsätze auch im Zusammenhang mit empfindlichen Leistungshalbleitern zur Anwendung gelangen können. Dazu ist jedes pyrotechnisch-mechanisches Element im Rahmen der Erfindung bezüglich der Leistungshalbleitermodule so angeordnet oder auf eine Weise ausgerüstet, dass die besagten Beschädigungen im Auslösefall durch die dann stattfindende Explosion sicher ausgeschlossen werden können.

Erfindungsgemäß verfügt jedes Leistungshalbleitermodul über wenigstens einen zugeordneten Energiespeicher, wie beispielsweise wenigstens einen Kondensator.

Im Rahmen der Erfindung weist das pyrotechnisch-mechanische Element ein Gehäuse auf, in dem der Sprengsatz angeordnet ist. Durch das Gehäuse ist beispielsweise ein Schutz für die Leistungshalbleitermodule bereitgestellt. Das Gehäuse ist zweckmäßigerweise so dick ausgestaltet, dass ein Zerbersten des Gehäuses oder sonstiger Teile des pyrotechnischenmechanischen Elementes im Explosionsfalle vermieden ist.

Erfindungsgemäß besteht das pyrotechnisch-mechanische Element wenigstens aus einem elektrisch leitfähigen Material und verbindet in einer Auslösestellung die Reihenschaltung mit einem Umgehungszweig, so dass dem pyrotechnisch-mechanischen Element zugeordnete Leistungshalbleitermodul überbrückt ist. Gemäß dieser Weiterentwicklung der Erfindung findet im Fehlerfall ein Stromfluss über das pyrotechnisch-mechanische Element selbst statt. Mit anderen Worten ist das pyrotechnisch-mechanische Element Teil des Umgehungszweiges für das fehlerhafte Leistungshalbleitermodul.

Das pyrotechnisch-mechanische Element ist elektrisch zündbar. Eine solche elektrische Zündung ist sowohl zuverlässig als auch kostengünstig.

Gemäß einer diesbezüglich zweckmäßigen Weiterentwicklung der Erfindung ist das Gehäuse im Auslösefall gasdicht, so dass ein Auftreten von Explosionsgasen vermieden ist. Auf diese Weise ist die Gefahr einer Beschädigung der Leistungshalbleitermodule durch den Sprengsatz bei einer Explosion nahezu vollständig vermieden. Das pyrotechnisch-mechanische Element ist so ausgestaltet, dass lediglich eine mechanische Verschiebung des Auslösemittels im Auslösefall stattfindet. Weitere Nebenwirkungen entstehen gemäß dieser Weiterentwicklung im Rahmen der Erfindung nicht. Im diesem Zusammenhang sind pyrotechnisch-mechanische Elemente bekannt geworden, die sich nach Zündung des Sprengsatzes bei Raumtemperatur, ohne äußere Explosionsgase frei zu setzen, lediglich bis zu etwa 60° Celsius erwärmen.

Vorteilhafterweise weist das pyrotechnisch-mechanische Element wenigstens zwei Ansteueranschlüsse zum Auslösen des Sprengsatzes auf. Durch das Vorsehen von zwei Ansteueranschlüssen ist eine redundante Ansteuerung des Sprengsatzes ermöglicht, wodurch die Zuverlässigkeit der Auslösung noch weiter erhöht wird.

Gemäß einer diesbezüglichen Weiterentwicklung weist das pyrotechnisch-mechanische Element wenigstens einen Messgeber zur Erfassung eines zu überwachenden elektrischen Signals des zugeordneten Leistungshalbleitermoduls auf, wobei jeder Messgeber mit einer Auslöseeinheit verbunden ist, die zum elektrischen Zünden des Sprengsatzes eingerichtet ist. Die Auslöseeinheit ist beispielsweise mit einer zweckmäßigen Logik ausgestattet, die zum Überprüfen des zu überwachenden Signals an Hand einer internen Logik eingerichtet ist. Das zu überwachende Signal ist beispielsweise einer Spannung, die beispielsweise an einem Kondensator des zu überwachenden Leistungshalbleitermoduls abfällt, einem Strom oder einer zeitliche Veränderung der besagten Spannung oder des besagten Stroms proportional. Wird eine Spannung überwacht, ist der Messgeber beispielsweise ein geeichter Spannungswandler, der ein der von der Spannung abhängiges Spannungssignal erzeugt, das von der Auslöseeinheit unter Gewinnung von Abtastwerten abgetastet wird, wobei die Abtastwerte durch einen Analog/Digitalwandler in digitale Spannungsmesswerte umgewandelt werden. Die digitalen Spannungsmesswerte können beispielsweise mit einem parametrisierten Schwellenwert verglichen werden. Abweichend davon ist jedoch eine analoge Auswertung der Messgebersignale möglich. Solche Auslösevorgänge sind dem Fachmann jedoch bestens bekannt, so dass an dieser Stelle nicht näher hierauf eingegangen zu werden braucht.

Vorteilhafterweise ist das verschiebbare Auslösemittel durch den Sprengsatz in das Gehäuse hinein verschiebbar. Solche pyrotechnisch-mechanischen Elemente sind auf dem Markt unter dem Begriff "Pinpuller" bekannt geworden. Gemäß dieser vorteilhaften Weiterentwicklung wirkt das pyrotechnisch-mechanische Element wie eine Verriegelung, wobei die Verriegelung nach der Auslösung des Sprengsatzes aufgehoben ist und beispielsweise eine vorgespannte Feder freigesetzt wird, die einen zugeordneten Schalter oder Kontakt schließt.

Selbstverständlich ist es auch möglich, das verschiebbare Auslösemittel aus dem Gehäuse hinaus zu verschieben, so dass die Schaltbewegung von dem pyrotechnisch-mechanischen Element unmittelbar erzeugbar ist. Die Schaltbewegung wird anschließend in eine zweckmäßige Kinematik eingeleitet, so dass Kontakte zum Überbrücken des jeweils zugeordneten Leistungshalbleitermoduls geschlossen werden. Pyrotechnisch-mechanische Elemente sind beispielsweise unter dem Begriff pyrotechnische Aktuatoren bekannt geworden. Vorteilhafterweise ist die Wegstrecke der Verschiebung auch in diesem Fall begrenzt ausgelegt, so dass die Gefahr einer Beschädigung von weiteren Bauteilen der Vorrichtung vermieden ist.

Zweckmäßigerweise verfügt die erfindungsgemäße Vorrichtung über einen Hilfskontakt, mit dessen Hilfe überprüfbar ist, ob das pyrotechnisch-mechanische Element nach einer Zündung ausgelöst hat.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: ein pyrotechnisch-mechanisches Element mit einer Auslöseeinheit in einer schematischen Darstellung,
- Figur 2: ein Ausführungsbeispiel eines pyrotechnischmechanischen Elementes und
- Figur 3: ein weiteres Ausführungsbeispiel gemäß Figur 2 zeigen.

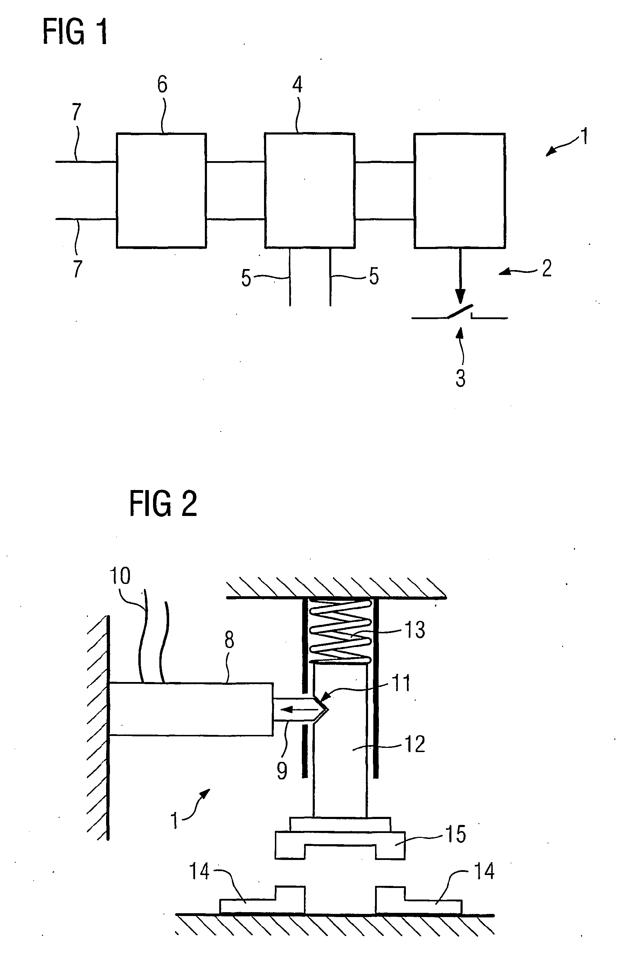

Figur 1 zeigt ein Ausführungsbeispiel eines pyrotechnisch-mechanischen Elements 1, das über ein gasdichtes Gehäuse verfügt, in dem ein Sprengsatz angeordnet ist. Durch die Auslösung des Sprengsatzes kommt es zur Verschiebung eines in Figur 1 nicht sichtbaren Auslösemittels, dessen Antriebsbewegung in eine zweckmäßige Kinematik 2 zum Schließen eines Schalters oder Kurzschließers 3 eingeleitet wird. Bei geschlossenem Schalter 3 ist ein Leistungshalbleitermodul überbrückt, das in einer Reihenschaltung von Leistungshalbleitermodulen angeordnet ist. Die besagte Reihenschaltung ist Teil eines Stromrichters.

Zum Auslösen des pyrotechnisch-mechanischen Elementes ist eine Ansteuereinheit 4 vorgesehen, die über Verbindungsleitungen 5 mit Messgebern verbunden ist, die in Figur 1 figürlich nicht dargestellt sind.

In dem Ausführungsbeispiel gemäß Figur 1 dient die Ansteuereinheit zum Überwachen eines Leistungshalbleitermoduls 1, das einen dem besagten Leistungshalbleitermodul 1 zugeordneten figürlich nicht dargestellten Energiespeicher beispielsweise in Form eines Kondensators aufweist. Die Ansteuereinheit 4 überwacht über die Verbindungsleitungen 5 die an dem Kondensator abfallende Spannung. Im Kurzschlussfall kommt es zum schnellen Zusammenbruch der Spannung. Überschreitet dieser Gradient eine bestimmte vorgegebene Schwelle, löst die Ansteuereinheit eine Explosion des Sprengsatzes des pyrotechnisch-mechanischen Elementes 1 aus, wodurch es zum Schließen des Schalters 3 kommt. Auf diese Weise ist das fehlerhafte Leistungshalbleitermodul überbrückt, so dass ein Stromfluss über die übrigen Leistungshalbleitermodule 1, die in Reihe zum fehlerhaften Leistungshalbleitermodul 1 geschaltet sind, ermöglicht ist.

Darüber hinaus kann auf das Überschreiten einer bestimmten Spannungsschwelle detektiert werden, woraus auf einen Fehler innerhalb des Leistungshalbleitermoduls 1 geschlossen werden kann. In diesem Fall wird dieses Leistungshalbleitermodul sofort kurzgeschlossen, beispielsweise um ein weiteres Anwachsen einer Kondensatorspannung, die an einem Kondensator des Leistungshalbleitermoduls abfällt, und damit einen höheren Energieinhalt im besagten Kondensator zu vermeiden.

Zur Energieversorgung der Ansteuereinheit ist eine Stromversorgungselektronik 6 vorgesehen, die über Anschlussleitungen 7 mit einer Stromversorgung verbunden ist.

Figur 2 zeigt ein Ausführungsbeispiel des pyrotechnisch-mechanischen Elementes 1, das über ein Gehäuse 8, einen Schaltstift 9 sowie eine Ansteuerleitung 10 verfügt. Die Explotion des Sprengsatzes im Innern des Gehäuses 8 bewirkt ein Einfahren des Schaltstiftes 9 in das Gehäuse 8. Dabei ist das Gehäuse 8 durch Einsatz zweckmäßiger Dichtungen gasdicht ausgebildet, so dass trotz der Explosion des Sprengsatzes das Auftreten von Explosionsgasen außerhalb des Gehäuses vermieden ist. Eine Beschädigung der empfindlichen Leistungshalbleiterbauelemente ist daher im Rahmen dieser Weiterentwicklung der Erfindung vermieden.

Der Schaltstift 9 dient in dem gezeigten Ausführungsbeispiel zur Verriegelung. Aus diesem Grunde ist die Spitze des Schaltstiftes 9 kegelförmig dargestellt, wobei die kegelförmige Spitze in eine komplementäre Ausnehmung 11 einer Schaltstange 12 eingreift. Im Normalbetrieb ist eine Druckfeder 13 durch die verriegelten Schaltstange 12 vorgespannt. Nach dem Auslösen des pyrotechnisch-mechanischen Elementes 1 ist die Verriegelung der Druckfeder 13 aufgehoben und die Druckfeder 13 freigesetzt, so dass es zum Überbrücken der Kontakte 14 durch die Kontaktbrücke 15 kommt. Kontaktiert die Kontaktbrücke 15 die Kontakte 14, ist das zugeordnete fehlerhafte Leistungshälbleiterbauelement überbrückt.

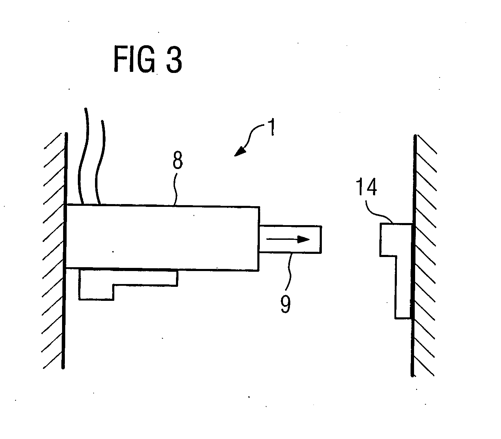

Figur 3 zeigt ein weiteres Ausführungsbeispiel des pyrotechnisch-mechanischen Elementes 1, das in dem gezeigten Ausführungsbeispiel vollständig aus einem leitenden Material, beispielsweise einem geeigneten Metall, gefertigt ist. Dem Ausführungsbeispiel gemäß Figur 2 entsprechend weist das in Figur 3 dargestellte pyrotechnische Element 1 ein Gehäuse 8 sowie einen Schaltstift 9 auf, wobei im Gegensatz zu dem in Figur 2 gezeigten Ausführungsbeispiel der Schaltstift 9 im Explosionsfalle des Sprengsatzes aus dem Gehäuse 8 herausfahrbar ausgestaltet ist. In der gezeigten Betriebsstellung ist der Schaltstift 9 vom Gegenkontakt 14 getrennt. In der ausgefahrenen Stellung ist jedoch ein Kontakt zwischen dem Schaltstift 9 und dem Gegenkontakt 14 bereitgestellt und somit ein Stromfluss über das pyrotechnisch-mechanische Element 1 ermöglicht und das fehlerhafte Leistungshalbleitermodul überbrückt.

## Patentansprüche

1. Vorrichtung mit Leistungshalbleitermodulen, die über wenigstens einen zugeordneten Energiespeicher verfügen und über Verbindungsmittel unter Ausbildung einer Reihenschaltung miteinander verbunden sind, wobei jedem Leistungshalbleitermodul eine Kurzschlusseinrichtung (1) zum Kurzschließen des jeweiligen Leistungshalbleitermoduls zugeordnet ist,
wobei die Kurschlusseinrichtung ein pyrotechnisch-mechanisches Element (1) ist, das einen Sprengsatz und ein durch den Sprengsatz verschiebbares Auslösemittel (9) aufweist, wobei das pyrotechnisch-mechanischen Element (1) aus einem elektrisch leitfähigen Material besteht und in einer Auslösestellung die Reihenschaltung mit einem Umgehungszweig verbindet, so dass das dem pyrotechnisch-mechanische Element (1) zugeordnete Leistungshalbleitermodul kurzgeschlossen ist, und wobei das pyrotechnisch-mechanische Element (1) elektrisch zündbar ist und ein Gehäuse (8) aufweist, in dem der Sprengsatz angeordnet ist.

2. Vorrichtung nach Anspruch 1,
**dadurch gekennzeichnet, dass** das Gehäuse (8) im Auslösefall gasdicht ist, so dass ein Auftreten von Explosionsgasen vermieden ist.

3. Vorrichtung nach einem der vorhergehenden Ansprüche,
**dadurch gekennzeichnet, dass** das pyrotechnisch-mechanische Element (1) wenigstens zwei Ansteueranschlüsse (10) zum Auslösen des Sprengsatzes aufweist.

4. Vorrichtung nach einem der vorhergehenden Ansprüche,
**dadurch gekennzeichnet, dass** das pyrotechnisch-mechanische Element (1) wenigstens einen Messgeber zur Erfassung eines zu überbewachenden elektrischen Signals des zugeordneten Leistungshalbleitermoduls aufweist, wobei jeder Messgeber mit einer Auslöseeinheit (4) verbunden ist, die zum elektrischen Zünden des Sprengsatzes eingerichtet ist.

5. Vorrichtung nach einem der vorhergehenden Ansprüche,
**dadurch gekennzeichnet, dass** das verschiebbare Auslösemittel (9) durch den Sprengsatz in das Gehäuse (8) hinein oder aus dem Gehäuse hinaus verschiebbar ist.

## Claims

1. Apparatus having power semiconductor modules which have at least one associated energy store and are connected to one another via connection means, forming a series circuit, with each power semiconductor module having an associated short-circuiting device (1) for short-circuiting of the respective power semiconductor module,
wherein
the short-circuiting device is a pyrotechnic/mechanical element (1) which has an explosive charge and an initiation means (9) which can be moved by the explosive charge, wherein the pyrotechnic/mechanical element (1) is composed of an electrically conductive material and, in an initiation position, connects the series circuit to a bypass branch such that the power semiconductor module which is associated with the pyrotechnic/mechanical element (1) is short-circuited, and wherein the pyrotechnic/mechanical element (1) can be triggered electrically and has a housing (8) in which the explosive charge is arranged.

2. Apparatus according to Claim 1,
**characterized in that**
the housing (8) is gas-tight when initiated, so as to avoid the occurrence of explosive gases.

3. Apparatus according to one of the preceding claims,
**characterized in that**
the pyrotechnic/mechanical element (1) has at least two drive connections (10) for initiation of the explosive charge.

4. Apparatus according to one of the preceding claims,
**characterized in that**
the pyrotechnic/mechanical element (1) has at least one measurement sensor for detection of an electrical signal to be monitored of the associated power semiconductor module, with each measurement sensor being connected to an initiation unit (4) which is designed for electrical triggering of the explosive charge.

5. Apparatus according to one of the preceding claims,
**characterized in that**
the movable initiation means (9) can be moved by the explosive charge into the housing (8) or out of the housing.

## Revendications

1. Dispositif comprenant des modules de puissance à semi-conducteurs, qui disposent d'au moins un accumulateur d'énergie associé et qui sont reliés les uns aux autres par des moyens de liaison avec formation d'un circuit série, dans lequel, à chaque module de puissance à semi-conducteurs, est associé un dispositif (1) de court-circuit pour court-circuiter le module de puissance à semi-conducteurs respectif, dans lequel
le dispositif de court-circuit est un élément ( 1 ) mécanique pyrotechniquement, qui a une charge explosive et un moyen ( 9 ) de déclenchement pouvant se déplacer dans la charge explosive, l'élément (1) mécanique pyrotechniquement étant constitué en un matériau conducteur de l'électricité et reliant dans une position de déclenchement le circuit série à une branche de contournement, de manière à court-circuiter le module de puissance à semi-conducteurs associé à l'élément ( 1 ) mécanique pyrotechniquement, et dans lequel l'élément ( 1 ) mécanique pyrotechniquement peut être amorcé électriquement et a un boîtier (8) dans lequel la charge explosive est disposée.

2. Dispositif suivant la revendication 1,
**caractérisé en ce que**
le boîtier ( 8 ) est étanche au gaz en cas de déclenchement, de manière à empêcher l'apparition de gaz d'explosion.

3. Dispositif suivant l'une des revendications précédentes,
**caractérisé en ce que**
l'élément (1) mécanique pyrotechniquement a au moins deux bornes ( 10 ) de commande pour le déclenchement de la charge explosive.

4. Dispositif suivant l'une des revendications précédentes,
**caractérisé en ce que**
l'élément (1) mécanique pyrotechniquement a au moins un indicateur de mesure pour la détection d'un signal électrique à contrôler du module de puissance à semi-conducteurs associé, chaque indicateur de mesure étant relié à une unité ( 4 ) de déclenchement, qui est conçue pour l'amorçage électrique de la charge explosive.

5. Dispositif suivant l'une des revendications précédentes,
**caractérisé en ce que**
le moyen ( 9 ) de déclenchement qui peut être déplacé peut, sous l'effet de la charge explosive, venir dans le boîtier ( 8 ) ou en sortir.
